# EUROPÄISCHE PATENTSCHRIFT

(11) **EP 2 991 466 B1**
(45) Veröffentlichungstag und Bekanntmachung des Hinweises auf die Patenterteilung: **09.08.2017**
(21) Anmeldenummer: 15172628.8
(22) Anmeldetag: 18.06.2015
(51) Int. Cl.: H05K 7/20, F25B 21/02, F28F 3/02

(54) **TEMPERIEREINRICHTUNG ZUM REGULIEREN DER TEMPERATUR IN EINEM RAUM UND SCHALTSCHRANK MIT EINER DERARTIGEN TEMPERIEREINRICHTUNG**
TEMPERING DEVICE FOR CONTROLLING THE TEMPERATURE IN A ROOM AND ELECTRICAL CABINET HAVING SUCH A TEMPERING DEVICE
DISPOSITIF DE RÉGULATION DE LA TEMPERATURE DANS UNE PIÈCE ET ARMOIRE ÉLECTRIQUE ÉQUIPÉE D'UN TEL DISPOSITIF DE RÉGULATION DE LA TEMPERATURE

(30) Priorität: 28.08.2014 DE 202014104040 U
(43) Veröffentlichungstag der Anmeldung: 02.03.2016
(73) Patentinhaber: Elmeko GmbH + Co. KG, 56479 Liebenscheid (DE)
(72) Erfinder: HERR, Burkhard, 57299 Burbach (DE)
(74) Vertreter: Grosse, Wolf-Dietrich Rüdiger

(56) Entgegenhaltungen:
- WO-A1-2005/055689
- WO-A1-2013/042553
- WO-A2-2008/125301
- DE-U1-202010 010 225
- JP-A- 2001 314 074
- US-A- 5 499 450
- US-B1- 6 244 331

## Beschreibung

Die Erfindung betrifft eine Temperiereinrichtung zum Regulieren der Temperatur in einem Raum, insbesondere in einem Schaltschrank mit elektronischen Einrichtungen.

Derartige Temperiereinrichtungen sind im Stand der Technik bekannt, z. B. für eine elektronische Anzeigeeinheit aus der deutschen Gebrauchsmusterschrift DE 20 2010 010 225 U1 sowie für einen Schaltschrank aus der internationalen Patentanmeldung WO 2008/125301 A2.

Konkret offenbart die internationale Patentanmeldung WO 2008/125301 A2 eine Temperiereinrichtung zum Regulieren der Temperatur in einem Schaltschrank, wobei die Temperiereinrichtung einen ersten Strömungskanal und einen zweiten Strömungskanal aufweist, welche räumlich benachbart, aber strömungstechnisch entkoppelt voneinander ausgebildet sind. Sowohl der erste Strömungskanal wie auch der zweite Strömungskanal umfassen jeweils einen Lufteinlass und einen Luftauslass sowie zwischen dem Lufteinlass und dem Luftauslass jeweils eine Reihenschaltung, bestehend aus einem Wärmeaustauschkörper sowie einem Lüfter zum Treiben der Luft durch den jeweiligen Strömungskanal. Zwischen dem Wärmeaustauschkörper des ersten Luftströmungskanals und dem Wärmeaustauschkörper des zweiten Luftströmungskanals ist bei der bekannten Temperiereinrichtung ein Temperierelement, z. B. in Form eines Peltier-Elementes angeordnet, welches in wärmeleitendem Kontakt mit den beiden Wärmetauscherkörpern angeordnet ist.

Ausgehend von diesem Stand der Technik liegt der Erfindung die Aufgabe zugrunde, eine bekannte Temperiereinrichtung zum Regulieren der Temperatur in einem Raum sowie einen Schaltschrank mit dieser Temperiereinrichtung dahingehend weiterzubilden, dass die Kühlleistung der Temperiereinrichtung verbessert wird.

Diese Aufgabe wird für die Temperiereinrichtung durch den Gegenstand des Schutzanspruchs 1 gelöst.

Die beanspruchten Stiftkühlkörper bestehen typischerweise aus einer reinen Aluminiumlegierung mit einer hohen Materialdichte. Dadurch ergibt sich eine sehr gute Wärmeleitung. Anstelle von durchgehenden Kühlrippen hat der Stiftkühlkörper einzelne runde Stifte als Kühlelemente. Diese besitzen insgesamt eine verhältnismäßig große Oberfläche und führen zu einer Verwirbelung der Luft bei Durchleitung durch den entsprechenden Luftströmungskanal, wodurch die Kühlleistung der Temperiereinrichtung vorteilhafterweise gegenüber Temperiereinrichtungen mit anderen Wärmetauscherkörpern deutlich erhöht wird.

Es ist ein ein- oder mehrteiliges Gehäuse vorgesehen, in welchem der erste und der zweite Luftströmungskanal ausgebildet sind, wobei der erste und der zweite Luftströmungskanal teilweise durch die Wandung des Gehäuses und / oder durch ein Kunststoffformteil, z. B. aus expandierendem Polypropylen, gebildet und begrenzt sind. Die verwendeten Kunststoffformteile dienen zur Aufnahme einzelner Bauteile der Temperiereinrichtung, wie z. B. zur Aufnahme der Lüfter oder der Wärmetauscher. Soweit die Kunststoffformteile zur Ausbildung des ersten und / oder zweiten Luftströmungskanals ausgebildet sind, dienen sie zum einen zur Trennung der beiden Luftströmungskanäle sowie zur Luftführung in den Luftströmungskanälen durch die jeweiligen Wärmetauscher.

Darüber hinaus dienen die Kunststoffformteile zur thermischen Isolation der Bauteile, wie der Lüfter und der Wärmetauscherelemente in den beiden strömungstechnisch getrennten Luftströmungskanälen, d. h. sie dienen zur Trennung von Kalt- und Warmseite. Der Begriff Kaltseite meint dabei denjenigen Strömungskanal, durch welchen die aus dem zu temperierenden Raum, z. B. aus dem zu temperierenden Schaltschrank abgeführte Luft geführt und gekühlt wird. Zum Kühlen strömt diese Luft an dem ersten Wärmetauscherkörper vorbei, wodurch dieser erwärmt wird. Die dabei entstehende Wärme wird über das Temperierelement zwischen den beiden Wärmetauscherkörpern an den Wärmetauscherkörper des zweiten Luftströmungskanals abgeführt; dieser wird durch die Luftströmung in dem zweiten Luftströmungskanal entsprechend gekühlt, wodurch die Wärme in die Umgebungsluft abgeführt wird.

Wie beansprucht, ist der zweite Wärmetauscherkörper des zweiten Luftströmungskanals als der besagte Stiftkühlkörper ausgebildet und sind die dem Temperierelement abgewandten Enden der Stiftelemente in wärmeleitendem Kontakt mit dem wärmeleitenden Teil des Gehäuses, d. h. dem Gehäusedeckel der Temperiereinrichtung stehend ausgebildet, welcher den Stiftkühlkörper überdeckt. Die wärmeleitende Verbindung zwischen den Stiftkühlkörpern und dem Deckel bewirkt vorteilhafterweise eine Vergrößerung der Kühlfläche und damit eine Verbesserung der Kühlleistung der Temperiereinrichtung.

Gemäß einem ersten Ausführungsbeispiel sind der erste und der zweite Luftströmungskanal strömungstechnisch entkoppelt voneinander ausgebildet.

Vorteilhafterweise ist das Temperierelement als mindestens ein Peltier-Element ausgebildet.

Weiterhin ist es vorteilhaft, wenn am Luftauslass des ersten Luftströmungskanals ein Absorber-Vlies vorgesehen ist zum Auffangen von Kondensat.

Um die wärmeleitende Verbindung zwischen den Stiftkühlkörpern und dem Gehäusedeckel weiter zu verbessern kann ein wärmeleitendes elastisches Kissen vorgesehen sein zwischen den Enden der Stiftelemente und dem Deckel des Gehäuses.

Die oben genannte Aufgabe der Erfindung wird weiterhin durch einen Schaltschrank zum Aufnehmen von Elektronik-Baugruppen gelöst, wobei der Schaltschrank mindestens eine der besagten erfindungsgemäßen Temperiereinrichtungen aufweist. Die Vorteile dieser Lösung entsprechen den oben mit Bezug auf die Temperiereinrichtung genannten Vorteilen. Die Temperiereinrichtung kann gemäß einem Ausführungsbeispiel vollständig außerhalb des Schaltschrankes auf eine von dessen Wänden montiert sein, wobei der erste Lufteinlass und der Luftauslass des ersten Luftströmungskanals über Löcher in der Seitenwand des Schaltschrankes mit dem Inneren des Schaltschrankes in strömungstechnischer Kommunikationsverbindung stehen.

Der Beschreibung sind zwei Figuren beigefügt, wobei
- Figur 1: einen Querschnitt durch die erfindungsgemäße Lüftereinrichtung; und
- Figur 2: eine Explosionsdarstellung von Einzelteilen der erfindungsgemäßen Temperiereinrichtung
zeigt.

Die Erfindung wird nachfolgend unter Bezugnahme auf die genannten Figuren in Form von Ausführungsbeispielen detailliert beschrieben. In allen Figuren sind gleiche technische Elemente mit gleichen Bezugszeichen bezeichnet.

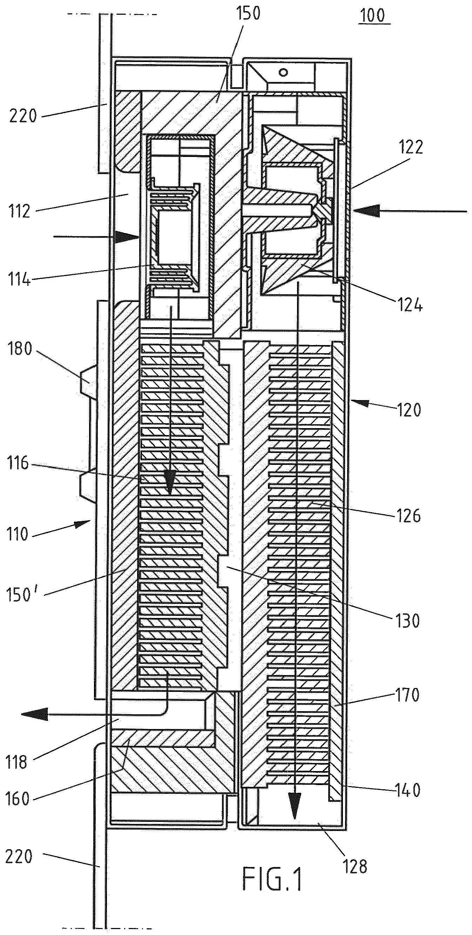

Figur 1 zeigt einen Querschnitt durch die erfindungsgemäße Temperiereinrichtung 100. In Figur 1 ist die Temperiereinrichtung 100 vollständig außen aufgesetzt auf eine Seitenwand 220 eines Schaltschrankes. Die Temperiereinrichtung 100 ist beispielsweise über eine Schraubbefestigung an der Seitenwand 220 des Schaltschrankes befestigt. Ein Stecker 180 dient für den Anschluss der elektrischen Energieversorgung.

Die Temperiereinrichtung 100 besteht im Wesentlichen aus einem ersten Luftströmungskanal 110 und einem zweiten Luftströmungskanal 120, wobei die Luftströmung in den beiden Strömungskanälen beispielhaft durch die Pfeile in Figur 1 angedeutet ist. Der erste Luftströmungskanal 110 umfasst einen Lufteinlass 112, durch welchen ein erster Lüfter 114 Luft z. B. aus dem Innern des Schaltschrankes ansaugt, um diese in Pfeilrichtung durch den ersten Luftströmungskanal, d. h. insbesondere durch den ersten Wärmetauscherkörper 116 und den nachfolgenden ersten Luftauslass 118 zu treiben. Der zweite Luftströmungskanal 120 ist analog aufgebaut. Auch er umfasst einen zweiten Lüfter 124 zum Ansaugen von Luft aus der Umgebung des Schaltschranks durch einen Lufteinlass 122 und zum Treiben der angesaugten Luft durch den zweiten Luftströmungskanal 120, d. h. insbesondere durch den zweiten Wärmetauscherkörper 126 zu dem zweiten Luftauslass 128. Der erste und der zweite Wärmetauscherkörper 116, 126 sind über ein Temperierelement 130, typischerweise ein Peltier-Element wärmeleitend miteinander verbunden. Erfindungsgemäß ist mindestens einer der beiden Wärmetauscherkörper 116, 126, vorzugsweise jedoch insbesondere der Wärmetauscherkörper des zweiten Luftströmungskanals 120 als Stiftkühlkörper ausgebildet.

Durch die Verwendung der Stiftkühlkörper kann die Kühlleistung der Temperiereinrichtung deutlich erhöht werden, wie oben beschrieben.

Die Kühlleistung der Temperiereinrichtung 100 kann dadurch darüber hinaus weiter vergrößert werden, dass die Kühlfläche von insbesondere dem zweiten Luftströmungskanal weiter vergrößert wird. Dies kann dadurch erreicht werden, dass die Stiftelemente des Stiftkühlkörpers in wärmeleitender Verbindung mit einem vorzugsweise aus Metall gebildeten Teil des Gehäuses 140 stehen; in diesem Fall wirkt der entsprechende Teil des Gehäuses als zusätzliche Kühlkörperfläche. Die wärmeleitende Verbindung zwischen den Stiftelementen und dem Gehäuse kann z. B. durch die Verwendung eines wärmeleitenden elastischen Kissens 170 zwischen den besagten Elementen verbessert werden.

Das Gehäuse der Temperiereinrichtung 100 kann ein- oder mehrteilig ausgebildet sein, das Gehäuse 140 kann zumindest teilweise, eventuell zusammen mit Kunststoffformteilen 150, die beispielsweise aus expandierendem Polypropylen gebildet sind, den ersten und den zweiten Luftströmungskanal bilden und begrenzen.

Schließlich ist es vorteilhaft, wenn am Auslass des ersten Luftströmungskanals ein Absorber-Vlies 160 vorgesehen ist zum Auffangen von Kondensat, welches sich durch Abkühlen der Luft an dem ersten Wärmetauscherkörper bildet.

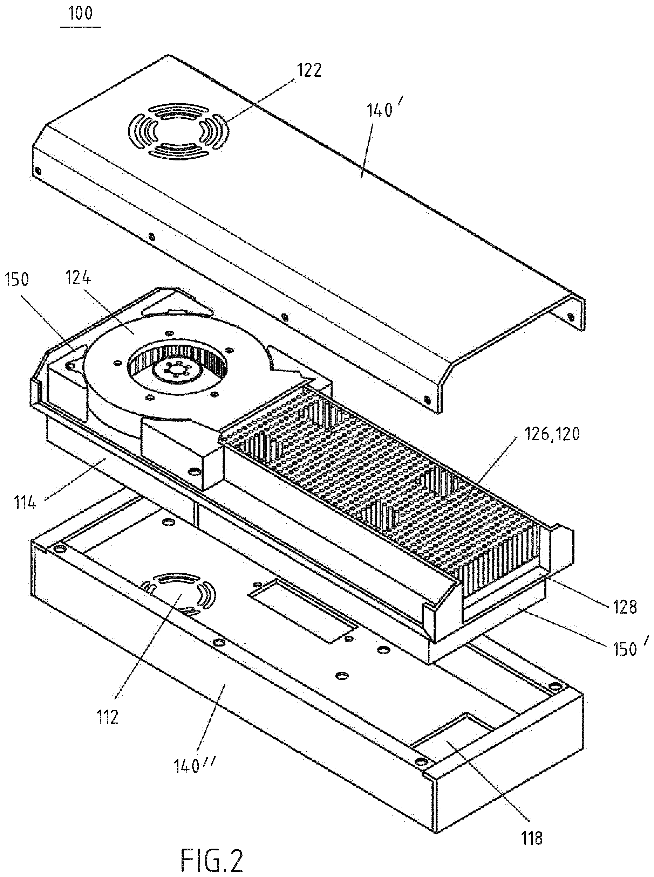

Figur 2 zeigt die erfindungsgemäße Temperiereinrichtung 100 in einer perspektivischen Explosionsdarstellung mit verschiedenen Einzelteilen. Zu erkennen ist ein Gehäuseunterteil 140" in Form einer Wanne, in welcher Öffnungen für den ersten Lufteinlass 112 und für den ersten Luftauslass 118 vorgesehen sind. In diese Wanne wird ein ein- oder mehrteiliges Kunststoffformteil 150 eingesetzt, welches als Träger für die einzelnen Komponenten des ersten und zweiten Luftströmungskanals 110, 120 fungiert. In Figur 2 ist insbesondere zu erkennen, dass ein erstes Kunststoffformteil 150 als Träger für die beiden Lüfter 114 und 124 fungiert. Ein zweites Kunststoffformteil 150' fungiert als Träger für die beiden Wärmetauscherkörper 116 und 126. Weiterhin ist ein oberes Gehäuseteil 140' zu erkennen, mit welchem der beschriebene zweite Luftströmungskanal 120 nach erfolgtem Zusammenbau der Temperiereinrichtung 100 abgedeckt wird. Dieser obere Gehäuseteil 140, 140', d. h. der Gehäusedeckel, kann bei entsprechender wärmeleitender Verbindung mit den Stiftelementen des zweiten Wärmetauscherkörpers 126 als zusätzliche Kühlfläche dienen.

### Bezugszeichenliste

- 100: Temperiereinrichtung
- 110: erster Luftströmungskanal
- 112: erster Lufteinlass
- 114: erster Lüfter
- 116: erster Wärmetauscherkörper
- 118: erster Luftauslass
- 120: zweiter Luftströmungskanal
- 122: zweiter Lufteinlass
- 124: zweiter Lüfter
- 126: zweiter Wärmetauscherkörper
- 128: zweiter Luftauslass
- 130: Temperierelement
- 140: Gehäuse
- 140': oberer Gehäuseteil (= Gehäusedeckel)
- 140": unterer Gehäuseteil
- 150: erstes Kunststoffformteil (= Träger für Lüfter)
- 150': zweites Kunststoffformteil (= Träger für Wärmetauscher)
- 160: Absorber-Vlies
- 170: wärmeleitendes elastisches Kissen
- 180: Stecker
- 220: Wandung des Schaltschrankes

## Patentansprüche

1. Temperiereinrichtung (100) zum Regulieren der Temperatur in einem Raum, insbesondere in einem Schaltschrank, mit:
- einem ersten Luftströmungskanal (110) mit einem ersten Lufteinlass (112) und einem ersten Luftauslass (118) und einer zwischen dem Lufteinlass und dem Luftauslass angeordneten Reihenschaltung aus einem ersten Wärmetauscherkörper (116) und einem ersten Lüfter (114) zum Treiben der Luft durch den ersten Luftströmungskanal;
- einen zweiten Luftströmungskanal (120) mit einem zweiten Lufteinlass (122) und einem zweiten Luftauslass (128) und einer zwischen dem Lufteinlass und dem Luftauslass angeordneten Reihenschaltung aus einem zweiten Wärmeaustauscherkörper (126) und einen zweiten Lüfter (124) zum Treiben der Luft durch den zweiten Luftströmungskanal (120);
- einem Temperierelement (130), welches in wärmeleitendem Kontakt mit dem ersten und dem zweiten Wärmetauscherkörper (116, 126) angeordnet ist; und
einem ein- oder mehrteiligem Gehäuse (140), in welchem der erste und der zweite Luftströmungskanal (110, 120) ausgebildet sind, wobei der erste und der zweite Luftströmungskanal teilweise durch die Wandung des Gehäuses (140) und/oder durch Kunststoffformteile (150, 150'),
gebildet und begrenzt sind,
**dadurch gekennzeichnet, dass**
der zweite Wärmetauscherkörper (126) des zweiten Luftströmungskanals (120) als Stiftkühlkörper ausgebildet ist; und
die dem Temperierelement (130) abgewandten Enden der Stiftelemente des Stiftkühlkörpers (126) in wärmeleitendem Kontakt mit dem wärmeleitenden, aus Metall gebildeten Teil des Gehäuses (140) der Temperiereinrichtung (100) stehen, welcher den Stiftkühlkörper (126) überdeckt.

2. Temperiereinrichtung (100) nach Anspruch 1,
**dadurch gekennzeichnet, dass**
der erste und der zweite Luftströmungskanal (110, 120) strömungstechnisch entkoppelt voneinander ausgebildet sind.

3. Temperiereinrichtung (100) nach einem der vorangegangenen Ansprüche,
**dadurch gekennzeichnet, dass**
das Temperierelement (130) als mindestens ein Peltier-Element ausgebildet ist.

4. Temperiereinrichtung (100) nach einem der vorangegangenen Ansprüche,
**gekennzeichnet, durch**
ein Absorber-Vlies (160) zum Auffangen von Kondensat am Luftauslass (118) des ersten Luftströmungskanals(110).

5. Temperiereinrichtung (100) nach Anspruch 1,
**dadurch gekennzeichnet, dass**
ein wärmeleitendes elastisches Kissen (170) vorgesehen ist zwischen den Enden der Stiftelemente und dem Teil des Gehäuses, welcher die Stiftelemente überdeckt.

6. Schaltschrank zum Aufnehmen von Elektronik-Baugruppen
**gekennzeichnet durch**
eine Temperiereinrichtung (100) nach einem der vorangegangenen Ansprüche, wobei die Temperiereinrichtung derart an oder in der Wandung (220) des Schaltschrankes montiert ist, dass der erste Lüfter (112) Luft aus dem Inneren des Schaltschrankes ansaugt, um die Luft durch den ersten Luftströmungskanal (110) zu treiben, und dass der zweite Lüfter (122) Luft von außerhalb des Schaltschranks ansaugt, um die Luft durch den zweiten Luftströmungskanal (120) zu treiben.

7. Schaltschrank nach Anspruch 6,
**dadurch gekennzeichnet, dass**
die Temperiereinrichtung (100) vollständig außerhalb des Schaltschranks auf eine von dessen Seitenwänden (220) montiert ist, wobei der erste Lufteinlass (112) und der erste Luftauslass (118) über Löcher in der Seitenwand (220) des Schaltschrankes mit dem Innern des Schaltschranks in strömungstechnischer Kommunikationsverbindung stehen.

## Claims

1. A temperature control device (100) for regulating the temperature in a space, in particular in a switchgear cabinet, having:
- a first air flow duct (110) having a first air inlet (112) and a first air outlet (118) and a series circuit, which is arranged between the air inlet and the air outlet and consists of a first heat exchanger body (116) and a first fan (114) for driving the air through the first air flow duct;
- a second air flow duct (120) having a second air inlet (122) and a second air outlet (128) and a series circuit, which is arranged between the air inlet and the air outlet and consists of a second heat exchanger body (126) and a second fan (124) for driving the air through the second air flow duct (120);
- a temperature control element (130), which is arranged in thermally conductive contact with the first and second heat exchanger bodies (116, 126); and
- a single- or multi-part housing (140), in which the first and second air flow ducts (110, 120) are formed, the first and second air flow ducts being formed and delimited in part by the wall of the housing (140) and/or by moulded plastic parts (150, 150');
**characterised in that**
the second heat exchanger body (126) of the second air flow duct (120) is in the form of a pin fin heat sink; and
the ends of the pin elements of the pin fin heat sink (126) that face away from the temperature control element (130) are in thermally conductive contact with the thermally conductive metal part of the housing (140) of the temperature control device (100), said part covering the pin fin heat sink (126).

2. The temperature control device (100) according to Claim 1,
**characterised in that**
the first and second air flow ducts (110, 120) are decoupled from each other in terms of flow.

3. The temperature control device (100) according to any one of the preceding claims,
**characterised in that**
the temperature control element (130) is in the form of at least one Peltier element.

4. The temperature control device (100) according to any one of the preceding claims,
**characterised by**
a fleece absorber (160) for collecting condensate at the air outlet (118) of the first air flow duct (110).

5. The temperature control device (100) according to Claim 1,
**characterised in that**
a thermally conductive elastic cushion (170) is provided between the ends of the pin elements and the part of the housing that covers the pin elements.

6. A switchgear cabinet for accommodating electronic modules,
**characterised by**
a temperature control device (100) according to any one of the preceding claims, wherein the temperature control device is mounted on or in the wall (220) of the switchgear cabinet in such a manner that the first fan (112) draws air out of the interior of the switchgear cabinet in order to drive the air through the first air flow duct (110) and that the second fan (122) draws air from outside the switchgear cabinet in order to drive the air through the second air flow duct (120).

7. The switchgear cabinet according to Claim 6,
**characterised in that**
the temperature control device (100) is mounted completely outside the switchgear cabinet on one of the side walls (220) thereof, wherein the first air inlet (112) and the first air outlet (118) communicate in terms of flow with the interior of the switchgear cabinet via holes in the side wall (220) of the switchgear cabinet.

## Revendications

1. Dispositif d'équilibrage de la température (100) destiné à réguler la température dans un espace, notamment dans une armoire de distribution, avec :
- un premier canal de circulation d'air (110) avec une première entrée d'air (112) et une première sortie d'air (118) et un couplage en série disposé entre l'entrée d'air et la sortie d'air, constitué d'un premier corps échangeur thermique (116) et d'un premier ventilateur (114) destiné à propulser l'air à travers le premier canal de circulation d'air ;
- un deuxième canal de circulation d'air (120) avec une deuxième entrée d'air (122) et une deuxième sortie d'air (128) et un couplage en série disposé entre l'entrée d'air et la sortie d'air, constitué d'un deuxième corps échangeur thermique (126) et d'un deuxième ventilateur (124) destiné à propulser l'air à travers le deuxième canal de circulation d'air (120) ;
- un élément d'équilibrage de la température (130), lequel est disposé en contact conducteur thermique avec le premier et le deuxième corps échangeurs thermiques (116, 126) ; et
- un boîtier (140) en une partie ou en plusieurs parties (140) dans lequel sont conçus les premier et le deuxième canaux de circulation d'air (110, 120), les premier et le deuxième canaux de circulation d'air étant formés et délimités en partie par la paroi du boîtier (140) et/ou par des pièces moulées (150, 150') en matière plastique
**caractérisé en ce que**
le deuxième corps échangeur thermique (126) du deuxième canal de circulation d'air (120) est conçu en tant dissipateur à picots ; et
les extrémités des éléments en picots du dissipateur à picots (126) qui sont opposées à l'élément d'équilibrage de la température (130) sont en contact conducteur thermique avec la partie conductrice thermique, conçue en métal du boîtier (140) du dispositif d'équilibrage de la température (100), laquelle recouvre le dissipateur à picots (126).

2. Dispositif d'équilibrage de la température (100) selon la revendication 1,
**caractérisé en ce que** les premier et deuxième canaux de circulation d'air (110, 120) sont conçus en étant désaccouplés l'un de l'autre du point de vue de la technique fluidique.

3. Dispositif d'équilibrage de la température (100) selon l'une quelconque des revendications précédentes,
**caractérisé en ce que** l'élément d'équilibrage de la température (130) est conçu en tant qu'au moins un élément Peltier.

4. Dispositif d'équilibrage de la température (100) selon l'une quelconque des revendications précédentes, **caractérisé par** un non-tissé absorbeur (160) pour recueillir des condensats à la sortie d'air (118) du premier canal de circulation d'air (110).

5. Dispositif d'équilibrage de la température (100) selon la revendication 1,
**caractérisé en ce qu'**il est prévu un coussin (170) élastique thermoconducteur entre les extrémités des éléments en picots et la partie du boîtier qui recouvre les éléments en picots.

6. Armoire de distribution destinée à réceptionner des ensembles électroniques,
**caractérisée par** un dispositif d'équilibrage de la température (100) selon l'une quelconque des revendications précédentes, le dispositif d'équilibrage de la température étant monté sur ou dans la paroi (220) de l'armoire de distribution, de telle sorte que le premier ventilateur (112) aspire de l'air à partir de l'intérieur de l'armoire de distribution pour propulser l'air à travers le premier canal de circulation d'air (110) et en ce que le deuxième ventilateur (122) aspire de l'air à partir de l'extérieur de l'armoire de distribution, pour propulser l'air à travers le deuxième canal de circulation d'air (120).

7. Armoire de distribution selon la revendication 6,
**caractérisée en ce que** le dispositif d'équilibrage de la température (100) est entièrement monté à l'extérieur de l'armoire de distribution, sur l'une des parois latérales (220) de celle-ci, la première entrée d'air (112) et la première sortie d'air (118) étant en liaison de communication technique fluidique avec l'intérieur de l'armoire de distribution par l'intermédiaire de trous dans la paroi latérale (220) de l'armoire de distribution.
